# EUROPEAN PATENT SPECIFICATION

(11) **EP 3 270 432 B1**
(45) Date of publication and mention of the grant of the patent: **03.07.2019**
(21) Application number: 17173638.2
(22) Date of filing: 31.05.2017
(51) Int. Cl.: H01L 51/44, H01L 31/0224, H01L 31/078

(54) **TANDEM SOLAR CELL AND TANDEM SOLAR CELL MODULE COMPRISING THE SAME**
TANDEMSOLARZELLE UND TANDEMSOLARZELLENMODUL DAMIT
CELLULE SOLAIRE EN TANDEM ET MODULE DE CELLULE SOLAIRE EN TANDEM LA COMPRENANT

(30) Priority: 13.07.2016 KR 20160088808
(43) Date of publication of application: 17.01.2018
(73) Proprietor: LG Electronics Inc., Seoul 07336 (KR)
(72) Inventor: Ahn, Seh-Won, 06772 Seoul (KR)
(74) Representative: Katérle, Axel

(56) References cited:
- US-A1- 2016 163 904
- US-A1- 2016 190 377
- DANIEL BRYANT ET AL: "A Transparent Conductive Adhesive Laminate Electrode for High-Efficiency Organic-Inorganic Lead Halide Perovskite Solar Cells", ADVANCED MATERIALS, vol. 26, no. 44, 1 November 2014 (2014-11-01), pages 7499-7504, XP055422409, DE ISSN: 0935-9648, DOI: 10.1002/adma.201403939
- BAILIE COLIN D ET AL: "Mechanically stacked and monolithically integrated perovskite/silicon tandems and the challenges for high efficiency", 2015 IEEE 42ND PHOTOVOLTAIC SPECIALIST CONFERENCE (PVSC), IEEE, 14 June 2015 (2015-06-14), pages 1-3, XP032828908, DOI: 10.1109/PVSC.2015.7355674 [retrieved on 2015-12-14]
- PAETZOLD ULRICH WILHELM ET AL: "Nanophotonic front electrodes for perovskite solar cells", APPLIED PHYSICS LETTERS, A I P PUBLISHING LLC, US, vol. 106, no. 17, 27 April 2015 (2015-04-27), XP012196982, ISSN: 0003-6951, DOI: 10.1063/1.4918751 [retrieved on 1901-01-01]
- COLIN D. BAILIE ET AL: "Semi-transparent perovskite solar cells for tandems with silicon and CIGS", ENERGY & ENVIRONMENTAL SCIENCE, vol. 8, no. 3, 23 December 2014 (2014-12-23), pages 956-963, XP055216407, ISSN: 1754-5692, DOI: 10.1039/C4EE03322A

## Description

### BACKGROUND

### 1. Technical Field

The present disclosure relates to a tandem solar cell, a tandem solar cell module comprising the tandem solar cell, and a method for manufacturing the same. More specifically, the present disclosure relates to a monolithic tandem solar cell comprising a perovskite solar cell laminated on a front surface of a crystalline silicon solar cell, a tandem solar cell module comprising the tandem solar cell, and a method for manufacturing the same.

### 2. Description of the Related Art

US 2016/0163904 A1 discloses a two-terminal multi-junction solar cell comprising a crystalline silicon sub-cell, a tunnel junction with a material having an indirect band gap a metal halide semiconductor sub-cell, and a top electrode diposed above a top surface of the metal halide semiconductor sub-cell.

Bryant et al. discloses in "A transparent conductive adhesive laminate electrode for high-efficiency organic-inorganic lead halide perovskite solar cells", Adv. Mater. 2014, 26, 7499-7504 a perosvkite solar cell with a SpiroOMeTad, PEDOT:PSS/TCA, Ni Mesh and PET/Embedded grid layers.

Bailie et al. discloses in "Mechanically stacked and monolightically integrated perovskite/silicon tandems and the challenges for high efficiency", 2015, IEEE 42nd Photovoltaic specialist conference, a monolithically integrated perovskite/silicon tandem solar cell.

US 2016/0190377 A1 discloses a tandem solar cell comprising a silicon based bottom cell bonded to a perovskite material based top cell. A front transparent electrode is disposed on a front surface of the perovskite solar cell.

Crystalline silicon (c-Si) solar cells are a typical single-junction solar cell and have dominated the solar cell market for decades.

However, although the bandgap of crystalline silicon is almost ideal when considering a Shockley-Queisser limit, the photoelectric conversion efficiency of silicon-based solar cells is limited to about 30% according to Auger recombination.

That is, the photovoltaic efficiency of the conventional crystalline silicon solar cell has a low threshold value due to thermalization loss occurring when photon with much higher energy than the bandgap is incident and transmission loss of photon with lower energy than the bandgap.

As used herein, the term "thermalization loss" means that excess energy of light absorbed by a solar cell is lost as thermal energy without being converted to a photon which is a quantum form of lattice vibration, and the term "transmission loss" means a loss caused by a photon having an energy lower than the bandgap not sufficiently exciting electrons.

In order to reduce the thermalization loss in a single junction solar cell, the bandgap with an appropriate size is required and the bandgap must be low to allow low energy photons to contribute, and therefore a trade-off relationship is established between them.

Since such a trade-off relationship is difficult to solve with a single junction solar cell, in recent years, attempts have been made to utilize light energy in a wide spectral range effectively by using materials having various energy bandgaps such as a tandem solar cell or a double-junction solar cell.

As one of these attempts, a tandem solar cell constituting one solar cell by connecting a single junction solar cell including an absorption layer having different bandgaps has been proposed.

In general, a single junction solar cell including an absorption layer having a relatively large bandgap is positioned on the front side to receive incident light first, and a single junction solar cell including an absorption layer having a relatively small bandgap is disposed on the rear side.

Accordingly, there is an advantage that the tandem solar cell absorbs light in a shorter wavelength region from the front side and absorbs light in a longer wavelength region from the rear side, thereby moving a threshold wavelength toward the longer wavelength side, such that the entire absorption wavelength region can widely be used.

In addition, by using the entire absorption wavelength region divided into two bands, a reduction in heat loss can be expected during electron-hole generation.

Such a tandem solar cell can roughly be classified into a two-terminal tandem solar cell and a four-terminal tandem solar cell depending on a junction type of the single junction solar cell and the location of electrodes.

Specifically, the two-terminal tandem solar cell has a structure in which two sub-solar cells are tunnel-junctioned, and electrodes are provided on the front and rear surfaces of the tandem solar cell, while the four-terminal tandem solar cell has a structure in which two sub-solar cells are spaced apart from each other and electrodes are provided on the front and rear surfaces of each sub-solar cell.

In the case of the four-terminal tandem solar cell, each sub-solar cell requires a separate substrate and requires a relatively large number of transparent conductive junctions as compared to the two-terminal tandem solar cell, resulting in high resistance and inevitably causing optical loss, and therefore two-terminal tandem solar cell has been attracting attention as a next generation solar cell.

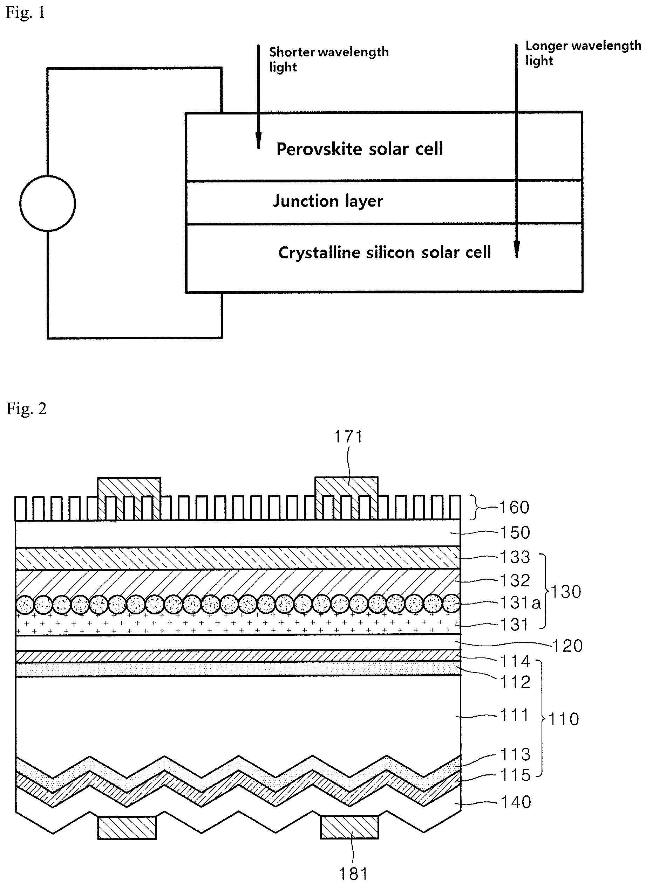

Fig. 1 is a schematic cross-sectional view of the conventional two-terminal tandem solar cell.

Referring to Fig. 1, the solar cell includes a single junction solar cell including an absorption layer having a relatively large bandgap and a single junction solar cell including an absorption layer having a relatively small bandgap, both cells of which are tunnel-junctioned via a junction layer.

Perovskite/crystalline silicon tandem solar cells have been attracting attention as potential candidates for achieving a photovoltaic efficiency of more than 30%, where a single junction solar cell including an absorption layer having a relatively large bandgap among various types of two-terminal tandem solar cells is used as a perovskite solar cell and a single junction solar cell including an absorption layer having a relatively small bandgap is used as a crystalline silicon solar cell.

In the perovskite/crystalline silicon tandem solar cell, a junction layer is formed on the front surface of the crystalline silicon solar cell, and then the perovskite solar cell is deposited on the front surface of the junction layer.

In this case, when a texture structure is formed on the surface of a crystalline silicon substrate to reduce the reflectance of incident light, there is a problem that the perovskite solar cell (particularly, an electron transport layer directly contacting the crystalline silicon solar cell) is not uniformly deposited.

Therefore, currently most of the perovskite/crystalline silicon tandem solar cells are formed by flattening the surface of a crystalline silicon substrate on which a perovskite solar cell is to be deposited, and then depositing the perovskite solar cell.

In this case, it is problematic that not only the reflectance of incident light is increased but also the optical path length of a longer wavelength absorbed by the crystalline silicon tandem solar cell arranged on the rear surface is reduced, so that the light absorption rate in the crystalline silicon tandem solar cell is lowered.

In addition, the incident light of a shorter wavelength selectively absorbed in the perovskite solar cell disposed on the front surface may be transmitted without being sufficiently collected in the perovskite absorption layer.

### SUMMARY

Accordingly, one object of the present disclosure is to provide a tandem solar cell having a structure capable of reducing a reflectance of light vertically incident on the tandem solar cell and increasing an optical path by changing the incidence direction of light to an oblique direction, and a tandem solar cell module including the same.

Another object of the present disclosure is to provide a tandem solar cell having a structure capable of selectively collecting light in a perovskite solar cell and a crystalline silicon solar cell, and a tandem solar cell module including the same.

Still another object of the present disclosure is to provide a tandem solar cell in which an optical efficiency and an actual power generation are improved by using a double-sided light receiving type homogeneous or heterogeneous silicon solar cell and a tandem solar cell module including the same.

Further, still yet another object of the present disclosure is to provide a method for manufacturing a tandem solar cell capable of reducing a reflectance of an incident light and increasing an optical path by introducing a nano-scaled, patterned optical structure on a front surface of the tandem solar cell.

According to an aspect of the present disclosure, there is provided a tandem solar cell including a junction layer disposed on a front surface of a crystalline silicon solar cell, a perovskite solar cell disposed on a front surface of the junction layer, and a front transparent electrode disposed on a front surface of the perovskite solar cell, wherein the front transparent electrode includes a patterned transparent electrode structure on the front surface thereof.

In certain embodiments, as the transparent electrode structure is patterned to have a concave-convex pattern or a grid pattern, it is possible to change the direction of light vertically incident on the tandem solar cell to an oblique direction, thereby reducing the reflectance of incident light and increasing the optical path. As the path of the incident light increases, the path of the light passing through a light absorption layer in the perovskite solar cell and the crystalline silicon solar cell increases, thereby improving a light absorption rate.

In certain embodiments, a front metal electrode for collecting charges generated from the perovskite solar cell is disposed on a part of a front surface of the front transparent electrode. The front metal electrode includes a pad electrode made of a metal, and an electrode wire. In certain embodiments, when forming a solar cell module using a plurality of tandem solar cells (i.e., a plurality of cells) according to the present disclosure, the electrode wire serves as a conductor for electrically connecting neighboring cells. In certain embodiments, the electrode wire has a cylindrical or elliptical cross section, so that the incident light reflected by the electrode wire can be reentered toward the solar cell.

In addition, a rear metal electrode for collecting charges generated from the crystalline silicon solar cell is not entirely provided on a rear surface of the rear transparent electrode but is disposed on a rear transparent electrode or a part of a rear surface of a rear passivation layer, so that the light of a longer wavelength that cannot be absorbed by the absorption layer of the crystalline silicon solar cell can be transmitted to the outside.

In certain embodiments, the rear metal electrode may be disposed on the rear transparent electrode or a part of the rear surface of the rear passivation layer so that the sunlight can be incident on the rear surface of the tandem solar cell as well as the front surface thereof.

According to another aspect of the present disclosure, there is provided a tandem solar cell module including a plurality of tandem solar cells, wherein the tandem solar cell includes a junction layer disposed on a front surface of a crystalline silicon solar cell, a perovskite solar cell disposed on a front surface of the junction layer, a front transparent electrode disposed on a front surface of the perovskite solar cell, a transparent electrode structure disposed on a front surface of the front transparent electrode, including a patterned transparent electrode, a front metal electrode disposed on a front surface of the transparent electrode structure, and a rear metal electrode disposed on a rear surface of the crystalline silicon solar cell.

In certain embodiments, the front metal electrode and the rear metal electrode of neighboring two tandem solar cells among the plurality of tandem solar cells are electrically connected to each other by electrode wires, and a front transparent substrate and a rear transparent substrate disposed with a gap between the front and rear surfaces of the plurality of tandem solar cells are included.

According to still another aspect of the present disclosure, there is provided a method for manufacturing a tandem solar cell, comprising: forming a crystalline silicon solar cell from a crystalline silicon substrate; forming a junction layer on a front surface of the crystalline silicon solar cell; forming a perovskite solar cell on a front surface of the junction layer; forming a front transparent electrode on a front surface of the perovskite solar cell; and patterning a transparent electrode structure on a front surface of the front transparent electrode.

In certain embodiments, the transparent electrode structure may be patterned so as to have a concave-convex pattern or a grid pattern by etching a predetermined depth from a front surface of the front transparent electrode after forming the front transparent electrode, or may be deposited as a separate layer on a front surface of the front transparent electrode.

According to the present disclosure, by way of arranging the patterned transparent electrode structure on a front surface of the front transparent electrode disposed on a front surface of the tandem solar cell, it is possible to reduce the reflectance of incident light by changing an incident angle of the light vertically incident on a front surface of the tandem solar cell.

In particular, even if a texture structure is not introduced on a front surface of the crystalline silicon solar cell, since the longer wavelength light transmitted through the perovskite solar cell is incident on the crystalline silicon solar cell in a diagonal direction, the reflection at an interface between the junction layer and the crystalline silicon solar cell can be reduced.

In addition, the light incident vertically toward the tandem solar cell can be refracted by the patterned transparent electrode structure on a front surface of the front transparent electrode and can be incident diagonally toward the perovskite solar cell and the crystalline silicon solar cell. As a result, the path of the incident light passing through each of the solar cells is increased, and eventually, the light absorption rate in each of the solar cells can be improved.

Further, according to the present disclosure, as the electrode wire for collecting the charges generated from the perovskite solar cell of the tandem solar cell has a cylindrical or elliptical cross section, it is possible to improve the efficiency by allowing the incident light reflected by the electrode wire to be re-incident on the solar cell.

In addition, since the rear metal electrode is disposed in a part of region, it is possible to realize a double-sided light receiving type of tandem solar cell, thereby further improving the efficiency of the tandem solar cell.

### BRIEF DESCRIPTION OF DRAWINGS

Fig. 1 schematically shows a cross section of a general tandem solar cell.
Fig. 2 shows a cross-sectional view of a tandem solar cell according to an embodiment of the present disclosure.
Figs. 3 and 4 show another embodiment of the transparent electrode structure applied to the tandem solar cell depicted in Fig. 2.
Figs. 5 and 6 schematically show paths for absorbing shorter wavelength light in the tandem solar cell depicted in Fig. 2.
Figs. 7 and 8 schematically show paths for absorbing longer wavelength light in the tandem solar cell depicted in Fig. 2.
Fig. 9 is a cross-sectional view of a tandem solar cell according to another embodiment of the present disclosure.
Figs. 10 and 11 show another embodiment of the transparent electrode structure applied to the tandem solar cell depicted in Fig. 9.
Fig. 12 shows a manufacturing procedure of the tandem solar cell depicted in Fig. 2.
Fig. 13 shows a manufacturing procedure of the tandem solar cell depicted in Fig. 9.
Fig. 14 schematically shows a modular form of the tandem solar cell according to the present disclosure.

### DETAILED DESCRIPTION

Hereinafter, a tandem solar cell according to a preferred embodiment of the present disclosure and a method for manufacturing the same will be described in detail with reference to the accompanying drawings.

It is to be understood that the present disclosure is not limited to the embodiments disclosed herein but may be embodied in various forms, and the exemplary embodiments set forth herein are only provided so that these disclosures will fully convey the sprit and scope of the invention to those skilled in the art.

### [Tandem solar cell]

The tandem solar cell described herein is generally assumed to be a double-sided light receiving type of tandem solar cell capable of receiving sunlight (or incident light) from both the front surface and the rear surface of the tandem solar cell, rather than receiving only from the front surface of the tandem solar cell.

### First embodiment

Fig. 2 shows a cross-sectional view of a tandem solar cell according to an embodiment of the present disclosure.

Referring to Fig. 2, the tandem solar cell according to the first embodiment of the present disclosure has a two-terminal tandem solar cell structure including a perovskite solar cell 130 including an absorption layer having a relatively large bandgap and a crystalline solar cell 110 including an absorption layer having a relatively small bandgap, wherein the perovskite solar cell 130 and the crystalline solar cell 110 are directly tunnel-bonded via a junction layer 120 (hereinafter referred to as "perovskite/crystalline silicon tandem solar cell").

Accordingly, the light in a shorter wavelength region of the light incident on the tandem solar cell is absorbed by the perovskite solar cell 130 disposed on the front side to generate electric charges, while the light in a longer wavelength region transmitted through the perovskite solar cell is absorbed by the crystalline silicon solar cell 110 disposed on the rear surface to generate electric charges.

The tandem solar cell having the above-described structure absorbs light at the shorter wavelength region in the perovskite solar cell 130 disposed on the front side to generate power, and absorbs light at the longer wavelength region in the crystalline silicon solar cell 110 disposed on the rear side to generate power, such that a threshold wavelength can be shifted to the longer wavelength side, and as a result, the advantage of broadening the wavelength band absorbed by the whole solar cells can be obtained.

However, in the case of the two-terminal tandem solar cell, since the perovskite solar cell 130 is directly tunnel-bonded to the front surface of the silicon solar cell 110 via the junction layer 120, the characteristics of the perovskite solar cell 130 may be influenced by the structure of the front surface of the crystalline silicon solar cell 110.

In a single-junction solar cell, it is common to introduce a texture structure on a surface in order to reduce a reflectance of incident light on the surface and to increase a path of light incident on the solar cell.

However, in the case of the perovskite/crystalline silicon tandem solar cell, problem may be arisen in that it is difficult to uniformly deposit the perovskite solar cell on the front surface of the crystalline silicon tandem solar cell when a texture structure is introduced on the whole surface of the crystalline silicon tandem solar cell. Accordingly, most of the perovskite/crystalline silicon tandem solar cells known so far have limitations that they must be realized on a front surface of flat wafer.

In this embodiment, there is a problem that the probability that the light in the longer wavelength region vertically incident to the crystalline silicon solar cell through particularly the perovskite solar cell is reflected at the interface between the junction layer and the crystalline silicon solar cell increases. Further, even if the light is not reflected but transmitted through the crystalline silicon solar cell, there is a problem that it is difficult to improve the absorption rate of the longer wavelength light because the optical path of the longer wavelength is shorter than that of the light incident in the diagonal direction.

In order to solve the problem of the conventional perovskite/crystalline silicon tandem solar cell, with the tandem solar cell according to the first embodiment of the present disclosure, the crystalline silicon solar cell 110 has a selective texture structure only on the rear surface thereof.

The crystalline silicon solar cell 110 according to the first embodiment may be implemented with a heterojunction crystalline silicon solar cell.

Specifically, the crystalline silicon solar cell 110 according to the first embodiment includes a crystalline silicon substrate 111, a front i-type amorphous silicon layer 112 located on a front surface of the crystalline silicon substrate 111, and a first conductive amorphous silicon layer 114 located on a front surface of the front i-type amorphous silicon layer 112. The front surface of the crystalline silicon substrate 111 is a portion where the light in a longer wavelength region transmitted through the perovskite solar cell 130 is first incident on the crystalline silicon solar cell 110.

Further, the rear surface of the crystalline silicon substrate 111 includes a rear i-type amorphous silicon layer 113 and a second conductive amorphous silicon layer 115 located on a rear surface of the rear i-type amorphous silicon layer 113.

In certain embodiments, when the crystalline silicon substrate 111 is an n-type single crystal silicon substrate, the first conductive amorphous silicon layer 114 is preferably a p-type amorphous silicon layer. That is, in order to improve the carrier mobility at the front surface where the amount of received light is relatively high as the light in the longer wavelength region is first incident on the crystalline silicon solar cell 110, it is preferable to configure reverse junction (p-n junction) in such a way that the p-type amorphous silicon layer is disposed on a front surface of the n-type single crystal silicon substrate, which can therefore improve a collection efficiency of the carrier. In this embodiment, the second conductive amorphous silicon layer 115 uses an n-type amorphous silicon layer to obtain a back surface electric field effect.

Further, the crystalline silicon substrate 111 may be a p-type single-crystal silicon substrate instead of an n-type single-crystal silicon substrate or another crystalline silicon substrate that is typically used in the crystalline silicon solar cell 110. Similarly, the first conductive amorphous silicon layer 114 and the second conductive amorphous silicon layer 115 may also be designed to have a proper conductivity according to conductivity of the crystalline silicon substrate 111.

The electric charge generated from the crystalline silicon solar cell 110 is collected in the rear transparent electrode 140 and the connection between the rear transparent electrode 140 and an external terminal is made via the rear metal electrode 180.

The rear transparent electrode 140 may be implemented as a variety of transparent conductive materials.

Examples of the transparent conductive material for implementing the rear transparent electrode 140 include a transparent conductive oxide, a carbonaceous conductive material, a metallic material, and a conductive polymer.

The transparent conductive oxide may include ITO (Indium Tin Oxide), ICO (Indium Cerium Oxide), IWO (Indium Tungsten Oxide), ZITO (Zinc Indium Tin Oxide), ZIO (Zinc Indium Oxide), ZTO (Zinc Tin Oxide), GITO (Gallium Indium Tin Oxide), GIO (Gallium Indium Oxide), GZO (Gallium Zinc Oxide), AZO (Aluminum doped Zinc Oxide), FTO (Fluorine Tin Oxide), or ZnO. The carbonaceous conductive material may include graphene or carbon nanotubes, and the metallic material may include metal (Ag) nanowires and metal thin films of multilayer structure such as Au/Ag/Cu/Mg/Mo/Ti. The conductive polymer may include polyaniline, polypyrrole, polythiophene, poly-3,4-ethylene dioxythiophene-polystyrene sulfonate (PEDOT-PSS), poly-[bis(4-phenyl)(2,4,6-trimethylphenyl)amine] (PTAA), Spiro-MeOTAD, or polyaniline-camphorsulfonic acid (PANI-CSA).

In this embodiment, as shown in Fig. 2, the rear metal electrode 180 is not provided on the rear surface of the rear transparent electrode 140 but is provided on a part of the rear surface of the rear transparent electrode 140, such that the sunlight may be incident on the rear surface of the crystalline silicon solar cell 110.

In this embodiment, it is preferable that the rear metal electrode 180 is arranged to occupy 1% to 30% of the total area of the rear surface of the rear transparent electrode 140. If the area occupied by the rear metal electrode 180 is less than 1%, the effect of collecting charges generated from the crystalline silicon solar cell 110 by the rear metal electrode 180 may be insufficient, whereas if the area occupied by the rear metal electrode 180 exceeds 30%, the area occupied by the rear metal electrode 180 is excessively wide, and the utilization of light incident from the rear surface of the crystalline silicon solar cell 110 may be reduced.

The rear metal electrode 180 includes a grid electrode 181 that contacts a portion of the rear surface of the rear transparent electrode 140 and collects charges on the rear surface. In addition, a pad electrode 182 may be provided to be in electrical contact with the grid electrode structure. The pad electrode 182 is provided with an electrode wire 183 for electrically connecting neighboring tandem solar cells in a modular configuration, and the electrode wire 183 connected to the rear surface of the pad electrode 182 of one cell is integrally provided with the electrode wire 173 connected to the pad electrode 172 of a neighboring cell.

In this embodiment, the electrode wire 183 is preferably a wire form having a cylindrical or elliptical cross section. Accordingly, the light incident from the rear surface of the crystalline silicon solar cell 110 is reflected and incident in an oblique direction, thereby increasing the optical path.

In addition, as a texture structure is introduced into the rear surface of the crystalline silicon substrate 111, and the silicon layers 113 and 115 and the rear transparent electrode 140 sequentially formed on the rear surface of the crystalline silicon substrate 111 are formed along the texture structure, the path of the light incident vertically through the rear surface of the crystalline silicon solar cell 110 can be changed to an oblique direction. That is, it is advantageous that light scattering effect by the texture structure introduced on the rear surface of the crystalline silicon solar cell 110 can increase the path of light incident from the rear surface of the crystalline silicon solar cell 110.

When the perovskite solar cell 130 is formed on the front surface of the silicon solar cell 110 by making the front surface of the crystalline silicon substrate 111 flat without introducing the texture structure as in the rear surface, it is possible to prevent the occurrence of defects in the perovskite solar cell 130.

Then, on the front surface of the first conductive amorphous silicon layer 114 of the crystalline silicon solar cell 110, a junction layer 120 for electrically connecting the crystalline silicon solar cell 110 and the perovskite solar cell 130 by tunnel-junction is located.

The junction layer 120 may be formed from for example a transparent conductive oxide, a carbonaceous conductive material, a metallic material, or a conductive polymer, in a manner similar to that of the rear transparent electrode 140 so that it electrically connects the crystalline silicon solar cell 110 and the perovskite solar cell 130 and simultaneously transmits the light of a longer wavelength transmitted through the perovskite solar cell 130 to the crystalline silicon solar cell 110 disposed on the rear surface thereof without transmission loss. In addition, the junction layer 120 may be doped with an n-type or p-type material. For example, it is also possible to apply an n-type or p-type amorphous silicon layer instead of the transparent electrode as the junction layer 120.

According to an alternative embodiment, the junction layer 120 may be formed in a multi-layer structure in which silicon layers having different refractive indexes are alternately laminated a plurality of times. In this embodiment, the multilayer structure may have a structure in which a lower refractive index layer and a higher refractive index layer are alternately laminated. Accordingly, the light having a shorter wavelength based on the junction layer 120 can be reflected to the perovskite solar cell 130, while the light having a longer wavelength can be transmitted to the crystalline silicon solar cell 110. This makes it possible to selectively collect light of the perovskite/crystalline silicon tandem solar cell.

In this embodiment, the above-described selective reflection and transmission of light can be realized by providing a structure in which a lower refractive index layer and a higher refractive index layer are alternately laminated on the front surface or the rear surface of the transparent conductive oxide layer or the n+ type silicon layer.

On the front surface of the junction layer 120 is positioned the perovskite solar cell 130.

The perovskite solar cell 130 includes an electron transport layer 131 located on a front surface of the junction layer 120, a perovskite absorption layer 132 located on a front surface of the electron transport layer, and a hole transport layer 133 positioned on a front surface of the perovskite absorption layer. In this embodiment, the electron transport layer 131 and the hole transport layer 133 may be substituted with each other as necessary.

The electron transport layer 131 located on the front surface of the junction layer 120 may include a metal oxide. Non-limiting examples of the metal oxide constituting the electron transport layer 131 include Ti oxides, Zn oxides, In oxides, Sn oxides, W oxides, Nb oxides, Mo oxides, Mg oxides, Zr oxides, Sr oxides, Yr oxides, La oxides, V oxides, Al oxides, Y oxides, Sc oxides, Sm oxides, Ga oxides, In oxides, and SrTi oxides. Preferably, the electron transport layer 131 may include at least one metal oxide selected from ZnO, TiO₂, SnO₂, WO₃, and TiSrO₃.

In addition, a mesoporous layer 131a including the same or different metal oxide as the electron transport layer 131 may be further provided on the front surface of the electron transport layer 131.

In this embodiment, the mesoporous layer 131a allows electrons to be easily transferred to the junction layer 120 after a hole-electron pair generated from the perovskite absorption layer 132 is decomposed into electrons or holes. In addition, the mesoporous structure formed on the mesoporous layer 131a may serve to further increase the optical path by allowing the transmitted light to be scattered.

The perovskite absorption layer 132 located on the front surface of the junction layer 120 is a photoactive layer containing a compound having a perovskite structure, wherein the perovskite structure can be represented by AMX₃ (where A is a monovalent organic ammonium or a metallic cation; M is a divalent metallic cation; and X is a halogen anion). Non-limiting examples of compounds having a perovskite structure include CH₃NH₃PbI₃, CH₃NH₃PbIxCl₃₋ₓ, CH₃NH₃PbIₓBr₃₋ₓ, CH₃NH₃PbClₓBr₃₋ₓ, HC(NH₂)₂PbI₃, HC(NH₂)₂PbIₓCl₃₋ₓ, HC(NH₂)₂PbIₓBr₃₋ₓ, HC(NH₂)₂PbClₓBr₃₋ₓ, (CH₃NH₃)(HC(NH₂)2)_{1-y}PbI₃, (CH₃NH₃)(HC(NH₂)₂)_{1-y}PbIₓCl₃₋ₓ, (CH₃NH₃)(HC(NH₂)₂)_{1-y}PbIₓBr₃₋ₓ, or (CH₃NH₃)(HC(NH₂)₂)_{1-y}PbClₓBr₃₋ₓ. Further, a compound in which A in AMX₃ is partially doped with Cs may also be used.

In this embodiment, the perovskite absorption layer 132 is preferably laminated on the front surface of the mesoporous layer 131a at a predetermined height while filling the mesopores of the mesoporous layer 131 a for improving an electron transfer.

The hole transport layer 133 located on the front surface of the perovskite absorption layer 132 may be formed of a conductive polymer referred to as a material for the rear transparent electrode 140. The hole transport layer 133 may further include an n-type or p-type dopant, if necessary.

The electric charge generated from the perovskite solar cell 130 having the above-described structure is collected in the front transparent electrode 150 and the connection between the front transparent electrode 150 and an external terminal is made via the front metal electrode 170.

The front rear transparent electrode 150 may be implemented as a variety of transparent conductive materials as the rear transparent electrode 140.

The tandem solar cell according to certain embodiments of the present disclosure reduces the reflectance of vertically incident light and changes the incidence direction of light to a diagonal direction, such that it further includes a transparent electrode structure 160 in a nano-sized patterned on the front surface of the front transparent electrode 150 in order to increase a light path passing through the tandem solar cell. In this embodiment, the transparent electrode structure 160 may have a lattice pattern such as a grid or a mesh pattern.

That is, by way of arranging the patterned transparent electrode structure 160 on the front surface of the front transparent electrode 150, it is possible to reduce the reflectance of the incident light by changing the incident angle of the light vertically incident on the tandem solar cell.

In particular, even if the texture structure is not introduced to the front surface of the crystalline silicon solar cell 110, the light having a longer wavelength transmitted through the perovskite solar cell 130 is refracted in a diagonal direction by the transparent electrode structure 160 toward the crystalline silicon solar cell 110, such that the reflectance at an interface between the junction layer 120 and the crystalline silicon solar cell 110 can be reduced.

In addition, the light incident vertically toward the tandem solar cell can be refracted by the patterned transparent electrode structure 160 and can be incident diagonally toward the perovskite solar cell 130 and the crystalline silicon solar cell 110. As a result, the path of the incident light passing through each solar cell is increased, and eventually, the light absorption rate in each solar cell can be improved.

The transparent electrode structure 160 may be formed of various transparent conductive materials as in the case of the front transparent electrode 150, and the transparent electrode structure 160 may be provided as a separate layer from the front transparent electrode 150 or may be integrally formed with the front transparent electrode 150.

For example, referring to Fig. 2, the front transparent electrode 150 and the transparent electrode structure 160 are provided as separate layers, and the transparent electrode structure 160 has a nano-sized structure or a grid or mesh pattern, such that the front transparent electrode 150 is exposed in some regions.

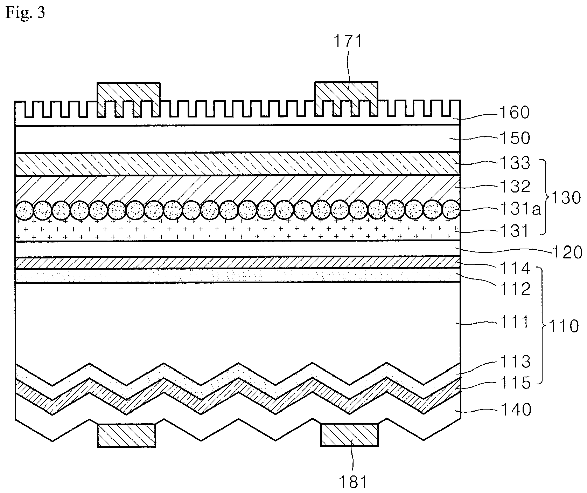

Referring to Fig. 3 according to another alternative embodiment, the front transparent electrode 150 and the transparent electrode structure 160 are provided as separate layers, and the transparent electrode structure 160 may be patterned in a concave-convex pattern.

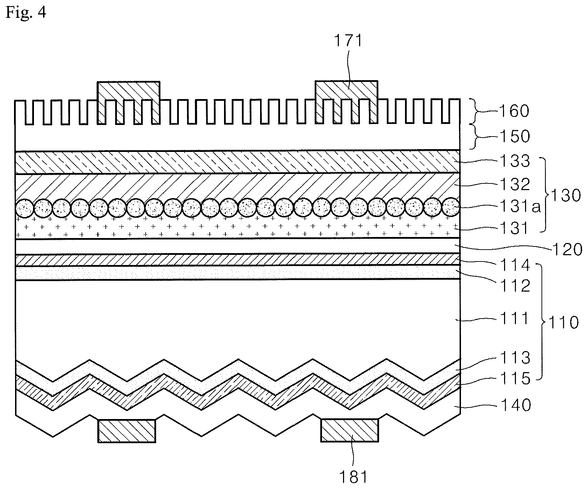

Referring to Fig. 4 according to another alternative embodiment, the front transparent electrode 150 and the transparent electrode structure 160 may be integrally formed, wherein the transparent electrode structure 160 may be formed by depositing a transparent electrode and then patterning the transparent electrode structure 160 by a predetermined depth from the front surface.

The front transparent electrode 150 and the transparent electrode structure 160 can be provided according to various modified embodiments described above to further improve the light collection effect in the tandem solar cell.

The front metal electrode 170 is provided in a part of the front surface of the front transparent electrode 150. The front metal electrode 170 includes a grid electrode 171 that contacts a portion of the front surface of the front transparent electrode 150. In addition, a grid electrode structure for collecting charges is formed on the front surface of the front transparent electrode 150, and a pad electrode 172 formed on a part of the front surface of the grid electrode structure, for example, in a direction connected to or intersecting with the grid electrode. The pad electrode 172 is provided with an electrode wire 173 for electrically connecting neighboring tandem solar cells when connecting modules of multiple cells, and the electrode wire 173 connected to the front surface of the pad electrode 172 of one cell is integrally provided with the electrode wire 183 connected to the rear surface of the pad electrode 172 of a neighboring cell. In this embodiment, the pad electrodes 172 and 182 and the electrode wires 173 and 183 may be solder-bonded using a conductive paste or the like.

In this embodiment, the electrode wire 173 is preferably a wire form having a cylindrical or elliptical cross section. Accordingly, the light incident vertically toward the electrode wire 173 can be scattered and the probability of re-entering into the tandem solar cell can be increased.

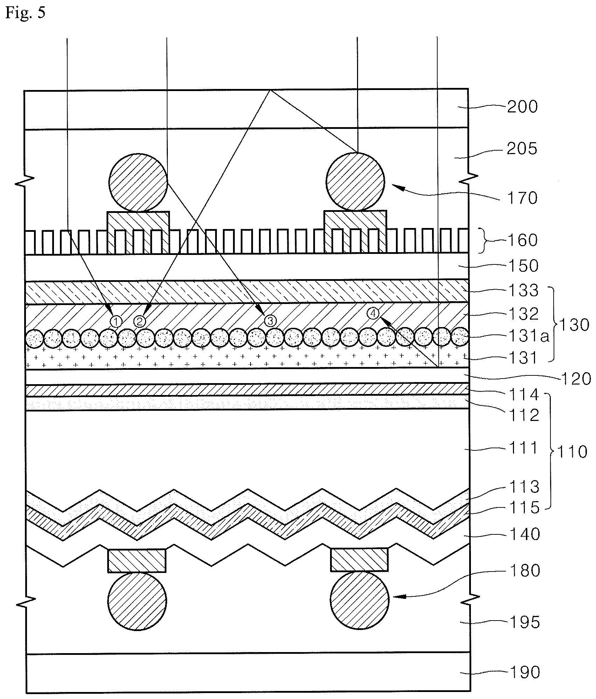

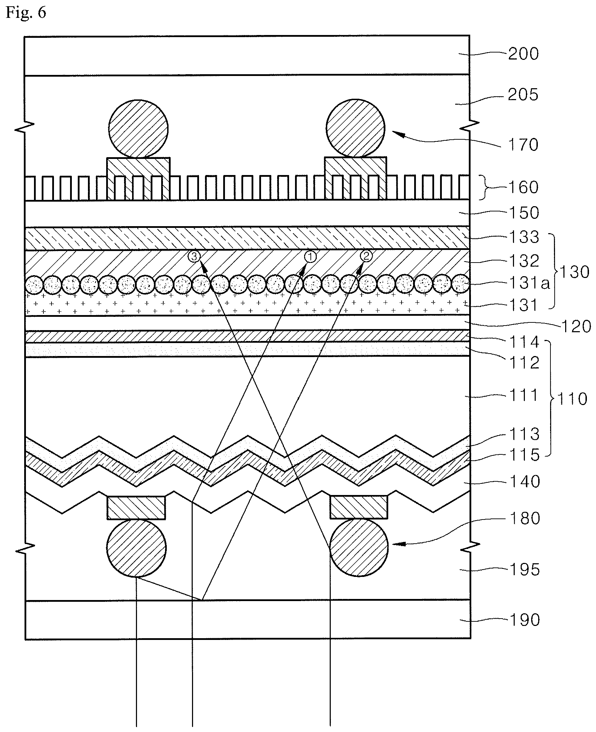

Figs. 5 and 6 schematically show paths for absorbing shorter wavelength light in the tandem solar cell depicted in Fig. 2, and Figs. 7 and 8 schematically show paths for absorbing longer wavelength light in the tandem solar cell depicted in Fig. 2.

Referring to Figs. 5 to 8, a transparent substrate 190 is disposed on the rear surface of the perovskite/crystalline silicon tandem solar cell shown in Fig. 2 with a gap 195 filled with an encapsulating material or a gas therebetween, and a transparent substrate 200 is provided on the front surface thereof with a gap 205 filled with an encapsulating material or a gas therebetween. In this embodiment, as for the transparent substrates 190 and 200, a glass substrate, a transparent polymer substrate, or the like may be used.

Fig. 5 shows various paths in which the light of a shorter wavelength incident from the front of the tandem solar cell in the perovskite solar cell 130 is absorbed.

First, the first optical path ① is an optical path in which shorter wavelength light is refracted by the transparent electrode structure 160 and is incident on the perovskite absorption layer 132 in an oblique direction. That is, by introducing a patterned transparent electrode structure 160 on the front surface of the perovskite solar cell 130, the path of the light vertically incident on the perovskite solar cell 130 is changed to a diagonal direction, such that the antireflection effect is obtained and at the same time the utilization rate of the shorter wavelength light in the perovskite absorption layer 132 can be improved by the increased optical path.

The second optical path ② and the third optical path ③ are paths in which shorter wavelength light is reflected by the front metal electrode 170 to which a wire-shaped metal wire having a cylindrical or elliptical cross section is connected.

In this embodiment, the second optical path ② is a light path in which light incident vertically toward the front surface of the front metal electrode 170 is reflected on the curved surface of the electrode wire and is incident on the transparent substrate 200 in a diagonal direction. The light incident on the transparent substrate 200 in an oblique direction can be reflected again and incident on the perovskite solar cell 130 in an oblique direction.

Accordingly, it is possible to increase the probability of re-entering into the perovskite solar cell 130 by scattering light vertically incident on the front metal electrode 170 in various directions.

The third optical path ③ is an optical path in which light incident vertically toward the side of the electrode wire is reflected and is incident on the perovskite solar cell 130 in an oblique direction. As a result, the utilization rate of the shorter wavelength light in the perovskite absorption layer 132 can be improved by the increased optical path while obtaining the antireflection effect.

The fourth optical path ④ is an optical path reflected by the junction layer 120 and re-incident on the perovskite absorption layer 132. To this end, preferably the junction layer 120 has a multi-layer structure having different refractive indexes so as to reflect light of a shorter wavelength to the perovskite absorption layer 132 and transmit light of a longer wavelength to the crystalline silicon solar cell 110.

Fig. 6 shows various paths in which the light of a shorter wavelength incident from the rear of the tandem solar cell in the perovskite solar cell 130 is absorbed.

First, the first optical path ① is a light path in which shorter wavelength light is refracted by a texture structure introduced on the rear surface of the crystalline silicon solar cell 110 and is incident on the perovskite solar cell 130 in an oblique direction. That is, by introducing a texture structure on the rear surface of the crystalline silicon solar cell 110, the optical path of a shorter wavelength vertically incident from the rear surface of the tandem solar cell is changed to an oblique direction, such that it is possible to obtain the antireflection effect and at the same time increase the optical path to improve the utilization rate of the shorter wavelength light in the perovskite solar cell 130.

The second optical path ② and the third optical path ③ are paths in which shorter wavelength light is reflected by the rear metal electrode 180 to which a wire-shaped metal wire having a cylindrical or elliptical cross section is connected.

In this embodiment, the second optical path ② is a light path in which light incident vertically toward the rear metal electrode 180 is reflected on the curved surface of the electrode wire bonded to the pad electrode 181 and is incident on the transparent substrate 190 in a diagonal direction. The light incident on the transparent substrate 190 in an oblique direction can be reflected again and incident on the perovskite solar cell 130 in an oblique direction.

Accordingly, it is possible to increase the probability of re-entering into the perovskite solar cell 130 by scattering light vertically incident on the rear metal electrode 180 in various directions.

The third optical path ③ is an optical path in which light incident vertically toward the side of the electrode wire is reflected and is incident on the perovskite solar cell 130 in an oblique direction. As a result, the utilization rate of the shorter wavelength light in the perovskite absorption layer 132 can be improved by the increased optical path while obtaining the antireflection effect.

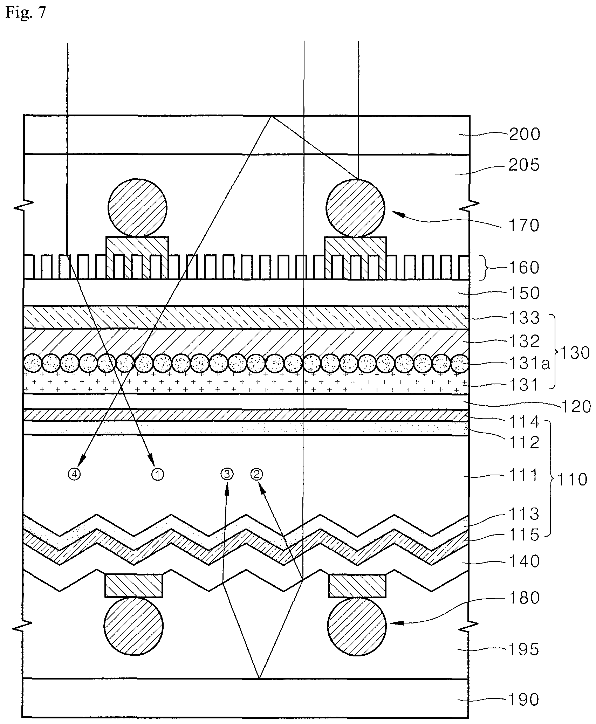

Fig. 7 shows various paths in which the light of a longer wavelength incident from the front surface of the tandem solar cell in the crystalline silicon solar cell 110 is absorbed.

First, the first optical path ① is an optical path in which longer wavelength light is refracted by the transparent electrode structure 160 and is incident on the crystalline silicon solar cell 110 in an oblique direction. That is, by introducing a transparent electrode structure 160 on the front surface of the perovskite solar cell 130, the optical path of a longer wavelength vertically incident toward the tandem solar cell is changed to an oblique direction, such that it is possible to obtain the antireflection effect and at the same time increase the optical path to improve the utilization rate of the longer wavelength light in the crystalline silicon solar cell 110.

The second optical path ② and the third optical path ③ are paths in which a longer wavelength is reflected by the rear transparent electrode 140 on which a textured structure is introduced, and the transparent substrate 190 disposed on a rear surface of the rear transparent electrode 140.

First, when the light of a longer wavelength reaches the rear transparent electrode 140 along the second optical path ②, a part of light is reflected and re-entered into the crystalline silicon solar cell 110. On the other hand, the light transmitted through the rear transparent electrode 140 is reflected in a diagonal direction again by the transparent substrate 190 and is incident again on the crystalline silicon solar cell 110, which corresponds to the third optical path ③.

In order to allow the light transmitted through the rear transparent electrode 140 to be emitted to the rear side as in the third optical path ③, the rear metal electrode 180 is provided only on a part of the rear surface of the rear transparent electrode 140. Accordingly, the longer wavelength light not absorbed by the crystalline silicon solar cell 110 can be emitted to the rear surface along the third optical path ③, and the light emitted to the rear surface can be reflected by the transparent substrate 190 and re-incident on the crystalline silicon solar cell 110, thereby improving the utilization rate of the longer wavelength light.

The fourth optical path ④ is a light path in which the light incident vertically toward the front surface of the front metal electrode 170 is reflected on the curved surface of the electrode wire and is incident on the transparent substrate 200 in a diagonal direction. The light incident in a diagonal direction toward the transparent substrate 200 may be reflected again and incident in a diagonal direction toward the tandem solar cell, and can reach the crystalline silicon solar cell 110 through the perovskite solar cell 130.

That is, it is possible to increase the probability of re-entering into the crystalline silicon solar cell 110 by scattering light vertically incident toward the electrode wire 173 in various directions.

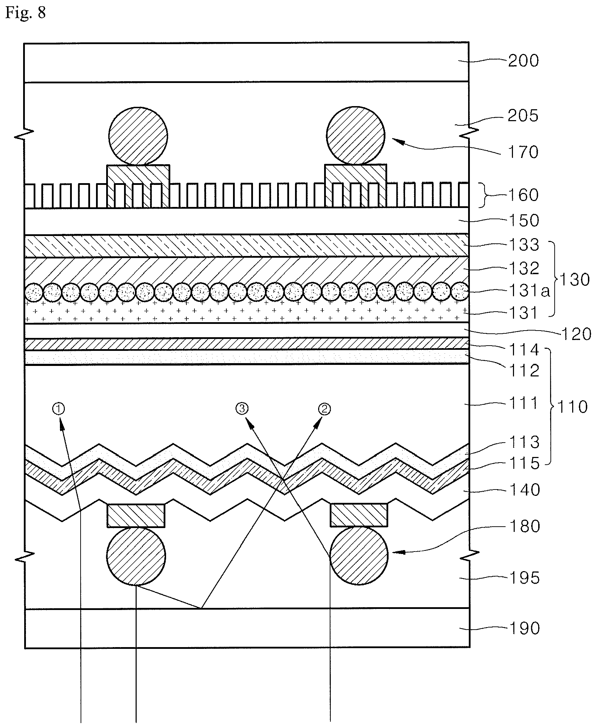

Fig. 8 shows various paths in which the light of a longer wavelength incident from the rear surface of the tandem solar cell in the crystalline silicon solar cell 110 is absorbed.

First, the first optical path ① is a light path in which the longer wavelength light is refracted by a texture structure introduced on the rear surface of the crystalline silicon solar cell 110 and is incident on the crystalline silicon solar cell 110 in an oblique direction. That is, by introducing a texture structure on the rear surface of the crystalline silicon solar cell 110, the optical path of a longer wavelength vertically incident from the rear surface of the tandem solar cell is changed to an oblique direction, such that it is possible to obtain the antireflection effect and at the same time increase the optical path to improve the utilization rate of the longer wavelength light in the crystalline silicon solar cell 110.

The second optical path ② and the third optical path ③ are paths in which longer wavelength light is reflected by the rear metal electrode 180 to which an electrode wire having a cylindrical or elliptical cross section is bonded.

In this embodiment, the second optical path ② is a light path in which the light incident vertically toward the rear metal electrode 180 is reflected on the curved surface of the electrode wire and is incident toward the transparent substrate 190 in a diagonal direction. The light incident on the transparent substrate 190 in an oblique direction can be reflected again and incident on the crystalline silicon solar cell 110 in an oblique direction.

Further, the third optical path ③ is an optical path in which the light incident vertically toward the side of the electrode wire is reflected and is incident toward the crystalline silicon solar cell 110 in an oblique direction.

### Second embodiment

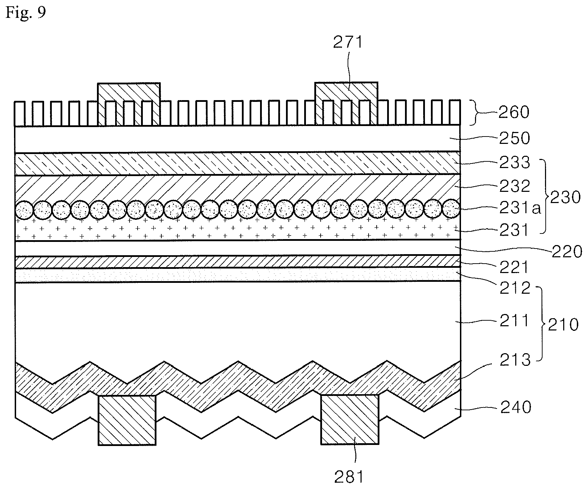

Fig. 9 shows a cross-sectional view of a tandem solar cell according to a second embodiment of the present disclosure.

The crystalline silicon solar cell 210 according to the second embodiment may be implemented with a homojunction crystalline silicon solar cell.

Specifically, the crystalline silicon solar cell 210 according to the second embodiment includes a crystalline silicon substrate 211, an emitter layer 212 located on a front surface of the crystalline silicon substrate 211, and a rear electric field layer 213 located on a rear surface of the crystalline silicon substrate 211. The front surface of the crystalline silicon substrate 211 is a portion where the light in a longer wavelength region transmitted through the perovskite solar cell 230 is first incident on the crystalline silicon solar cell 210.

In this embodiment, an impurity doping layer having conductivity different from that of the crystalline silicon substrate is used as the emitter layer 212, and an impurity doping layer having the same conductivity as the crystalline silicon substrate is used as the rear electric field layer 213, thereby providing a homojunction crystalline silicon solar cell.

For example, when the crystalline silicon substrate 211 is an n-type single crystal silicon substrate, the emitter layer 212 is a semiconductor layer doped with p-type impurities, and the rear electric field layer 213 is a semiconductor layer doped with n-type impurities. In this embodiment, the rear electric field layer 213 may be a p+ type semiconductor layer doped at a higher concentration than the concentration of the p-type impurity doped into the crystalline silicon substrate 211.

Further, the crystalline silicon substrate 211 may be a p-type single-crystal silicon substrate instead of an n-type single-crystal silicon substrate or another crystalline silicon substrate that is typically used for the crystalline silicon solar cell 210. Similarly, the emitter layer 212 and the rear electric field layer 213 may also be designed to be doped with an impurity having a suitable conductivity according to the conductivity of the crystalline silicon substrate 211.

A front passivation layer 221 and a rear passivation layer 240 are disposed on the front surface of the emitter layer 212 and the rear surface of the rear electric field layer 213, respectively. Particularly, the front passivation layer 221 may be disposed to cover the defect of the front surface of the emitter layer 212 and at the same time to ensure conductivity for the tunnel junction via the junction layer 220.

The front passivation layer 221 and the rear passivation layer 240 may be made of at least one dielectric material selected from silicon oxide (SiOₓ), silicon nitride (SiₓN_{y}), and silicon oxynitride (SiOₓN_{y}).

The electric charge generated from the crystalline silicon solar cell 210 is collected in the rear metal electrode 280. In this embodiment, the rear metal electrode 280 is located on a part of the rear surface of the rear passivation layer 240, contacting the rear surface of the rear electric field layer 213 through the rear passivation layer 240.

In this embodiment, as shown in Fig. 9, the rear metal electrode 280 is not provided on the rear surface of the rear passivation layer 240 but is provided on a part of the rear surface of the rear passivation layer 240, such that the sunlight may be incident on the rear surface of the crystalline silicon solar cell 210.

In this embodiment, it is preferable that the rear metal electrode 280 is arranged to occupy 1% to 30% of the total area of the rear surface of the rear passivation layer 240. If the area occupied by the rear metal electrode 280 is less than 1%, the effect of collecting charges generated from the crystalline silicon solar cell 210 by the rear metal electrode 280 may be insufficient, whereas if the area occupied by the rear metal electrode 280 exceeds 30%, the area occupied by the rear metal electrode 280 is excessively wide, and the utilization of light incident from the rear surface of the crystalline silicon solar cell 210 may be reduced.

In addition, a grid electrode structure for collecting charges is formed on the front surface of the front transparent electrode 213, and the pad electrode 282 may be provided to contact a part of the front surface of the grid electrode structure. On the pad electrode 282 is bonded by soldering method an electrode wire 283 for electrically connecting neighboring tandem solar cells, and the electrode wire 283 connected to the rear surface of the pad electrode 281 of one cell is integrally provided with the electrode wire 273 connected to the front surface of the pad electrode 272 of a neighboring cell. In this embodiment, the electrode wire 283 is preferably a wire form having a cylindrical or elliptical cross section.

In addition, the path of the light incident vertically through the rear surface of the crystalline silicon solar cell 210 can be changed to an oblique direction, as a texture structure is introduced into the rear surface of the crystalline silicon substrate 211, and the rear electric field layer 213 and the rear passivation layer 240 sequentially formed on the rear surface of the crystalline silicon substrate 211 are formed along the texture structure. That is, it is advantageous that light scattering effect by the texture structure introduced on the rear surface of the crystalline silicon solar cell 210 can increase the path of light incident from the rear surface of the crystalline silicon solar cell 210.

When the perovskite solar cell 230 is formed on the front surface of the silicon solar cell 210 by making the front surface of the crystalline silicon substrate 211 flat without introducing the texture structure as in the rear surface, it is possible to prevent the occurrence of defects in the perovskite solar cell 230.

Then, on the front surface of the emitter layer 212 of the crystalline silicon solar cell 210, a junction layer 220 for electrically connecting the crystalline silicon solar cell 210 and the perovskite solar cell 230 by tunnel-junction is located.

In this embodiment, the junction layer 220 may be formed in a multi-layer structure in which an n+ type crystalline silicon layer and a p+ type crystalline silicon layer are alternately laminated at least once.

On the front surface of the junction layer 220 is positioned the perovskite solar cell 230. The perovskite solar cell 230 includes an electron transport layer 231 located on a front surface of the junction layer 220, a perovskite absorption layer 232 located on a front surface of the electron transport layer, and a hole transport layer 233 positioned on a front surface of the perovskite absorption layer. In addition, a mesoporous layer 231a including the same or different metal oxide as the electron transport layer 231 may be further provided on the front surface of the electron transport layer 231.

The electric charge generated from the perovskite solar cell 230 having the above-described structure is collected in the front transparent electrode 250 and the connection between the front transparent electrode 250 and an external terminal is made via the front metal electrode 270. Examples of the transparent conductive material for implementing the front transparent electrode 250 include a transparent conductive oxide, a carbonaceous conductive material, a metallic material, and a conductive polymer

The tandem solar cell according to certain embodiments of the present disclosure reduces the reflectance of vertically incident light and changes the incidence direction of light to diagonal direction, such that it further includes a transparent electrode structure 260 having a nano-sized structure or patterned to have a lattice pattern such as a grid or a mesh pattern on the front surface of the front transparent electrode 250 in order to increase a light path passing through the tandem solar cell.

That is, by way of arranging the patterned transparent electrode structure 260 on the front surface of the front transparent electrode 250, it is possible to reduce the reflectance of the incident light by changing the incident angle of the light vertically incident on the tandem solar cell.

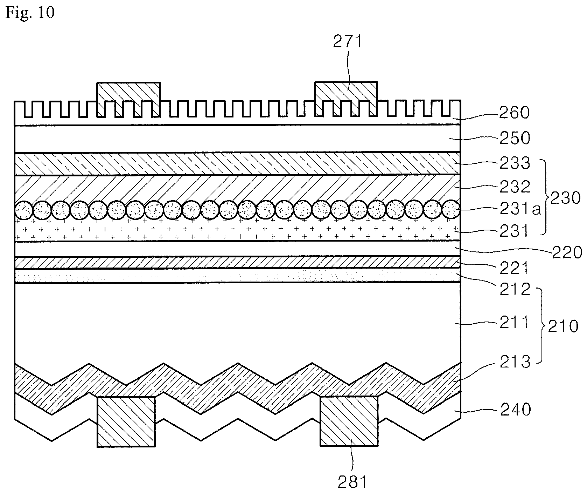

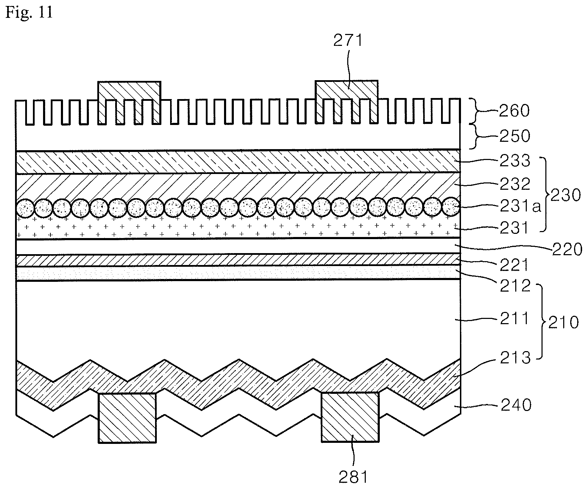

As shown in Figs. 9 and 10, the front transparent electrode 250 and the transparent electrode structure 260 are provided as separate layers, and the transparent electrode structure 260 has a grid, mesh, or concave-convex pattern, such that the front transparent electrode 250 can be exposed in some regions. Further, as shown in Fig. 11, the front transparent electrode 250 and the transparent electrode structure 260 may be integrally formed, wherein the transparent electrode structure 260 may be formed by depositing a transparent electrode and then patterning the transparent electrode structure 160 by a predetermined depth from the front surface.

The front metal electrode 270 is provided on a part of the front surface of the front transparent electrode 250. The front metal electrode 270 includes a pad electrode 272 that contacts a portion of the front surface of the front transparent electrode 250. In addition, a grid electrode structure for collecting charges is formed on the front surface of the front transparent electrode 250, and the pad electrode 272 may be provided to contact a part of the front surface of the grid electrode structure. On the front surface of the pad electrode 272 is bonded by soldering method an electrode wire 273 for electrically connecting neighboring tandem solar cells, and the electrode wire 273 connected to the front surface of the pad electrode 272 of one cell is integrally provided with the electrode wire 283 connected to the rear surface of the pad electrode 282 of a neighboring cell.

In this embodiment, the electrode wire 273 is preferably a wire form having a cylindrical or elliptical cross section. Accordingly, the light incident vertically toward the electrode wire 273 can be scattered and the probability of re-entering into the tandem solar cell can be increased.

### [Method for manufacturing a tandem solar cell]

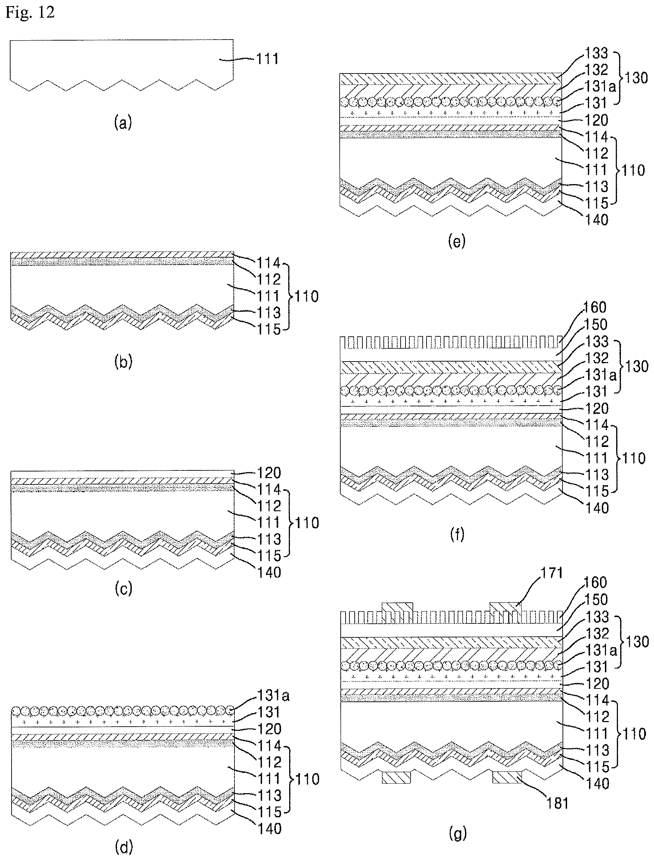

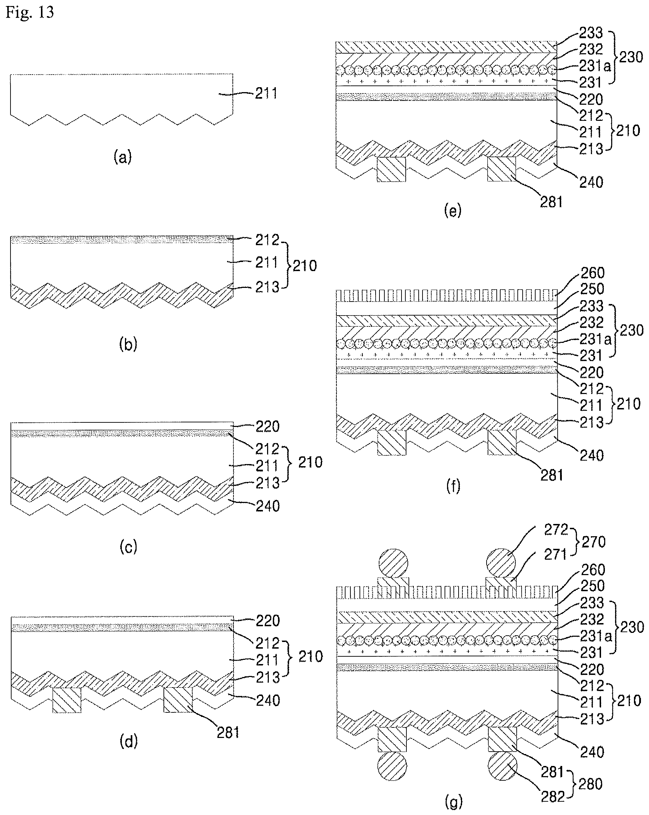

Fig. 12 shows a manufacturing procedure of the tandem solar cell depicted in Fig. 2, and Fig. 13 shows a manufacturing procedure of the tandem solar cell depicted in Fig. 9.

### Preparation of a crystalline silicon solar cell

Figs. 12A and 13A show the steps of preparing crystalline silicon substrates 111 and 211 for a crystalline silicon solar cell, and Figs. 12B and 13B show a step of preparing crystalline silicon solar cells 110 and 210 from the crystalline silicon substrates 111 and 211, respectively.

Referring to Fig. 12A, before the i-type amorphous silicon layer and the conductive amorphous silicon layer are formed on the front surface and the rear surface of the crystalline silicon substrate 111, respectively, the front surface of the crystalline silicon substrate 111 is chemically planarized and a texture structure is introduced to the rear surface thereof.

Further, Referring to Fig. 13A, before the emitter layer and the rear electric field layer are formed on the front surface and the rear surface of the crystalline silicon substrate 211, respectively, the front surface of the crystalline silicon substrate 211 is chemically planarized and a texture structure is introduced to the rear surface thereof.

The planarization and texture structure of the crystalline silicon substrate according to Figs. 12A and 13A can be introduced by any one of a wet chemical etching method, a dry chemical etching method, an electrochemical etching method, and a mechanical etching method, but not limited thereto. For example, the front and rear surfaces of the crystalline silicon substrate are etched in a basic aqueous solution (wet chemical etching method) to introduce a texture structure on both sides, and then a silicon substrate having a flat front surface and a rear surface with a textured structure can be obtained through selective etching on the front side of the silicon substrate. The selective etching for the front surface of the silicon substrate may be performed by forming a passivation layer on the rear surface and then performing etching or spraying an etchant only on the front surface of the silicon substrate.

Each of the layers sequentially formed on the rear surface of the crystalline silicon substrates 111 and 211 as a result of introducing the texture structure on the rear surface of the crystalline silicon substrates 111 and 211 may have a texture structure conforming to the texture structure formed on the rear surface of the crystalline silicon substrates 111 and 211. On the other hand, since the front surfaces of the crystalline silicon substrates 111 and 211 have undergone the planarization process, the respective layers sequentially formed on the front surfaces of the crystalline silicon substrates 111 and 211 can be formed flat. However, if necessary, the present disclosure may further include a patterning process such as etching an arbitrary layer among a plurality of layers formed on the front surface of the crystalline silicon substrates 111 and 211 to introduce irregularities.

Subsequently, referring to Fig. 12B, a front i-type amorphous silicon layer 112 and a rear i-type amorphous silicon layer 113 are formed on the front surface and the rear surface of the crystalline silicon substrate 111, respectively, and then a first conductive amorphous silicon layer 114 is formed on the front surface of the front i-type amorphous silicon layer 112 and a second conductive amorphous silicon layer 115 is formed on the rear surface of the rear i-type amorphous silicon layer 113.

In this embodiment, the i-type amorphous silicon layer, the first conductive amorphous silicon layer, and the second conductive amorphous silicon layer can be deposited by various known methods, and typically used is a chemical vapor deposition (CVD). The chemical vapor deposition method includes atmospheric pressure CVD, reduced pressure CVD, plasma CVD (PECVD), electron cyclotron resonance (ECR) plasma CVD, high temperature CVD, and low temperature CVD. In this embodiment, the i-type amorphous silicon layer may be deposited to a thickness of 2 to 10 nm, and the first conductive amorphous silicon layer and the second conductive amorphous silicon layer may be deposited to a thickness of 10 to 80 nm.

Referring to Fig. 13B, an emitter layer 212 and a rear electric field layer 213 are formed on the front and rear surfaces of the crystalline silicon substrate 211, respectively.

The emitter layer 212 and the rear electric field layer 213 may be formed through an implantation process, wherein the emitter layer 212 is doped with boron as an impurity and the rear electric field layer 213 is doped with phosphorous as an impurity. When the emitter layer 212 and the rear electric field layer 213 are formed by the implantation process, it is preferable to carry out a heat treatment at 700 to 1,200°C for activation of impurities. It is also possible to form the emitter layer 212 and the rear electric field layer 213 through a high temperature diffusion process using for example BBr₃ or POCl₃ instead of the implantation process.

Referring to Fig. 12C, a rear transparent electrode 140 is formed on the rear surface of the crystalline silicon solar cell 110, and a junction layer 120 is formed on the front surface thereof.

The junction layer 120 and the rear transparent electrode 140 may be formed from a variety of transparent conductive materials. Examples of the transparent conductive material for forming the junction layer 120 and the rear transparent electrode 140 include a transparent conductive oxide, a carbonaceous conductive material, a metallic material, or a conductive polymer.

For example, when a transparent conductive oxide such as ITO (Indium Tin Oxide), ICO (Indium Cerium Oxide), or IWO (Indium Tungsten Oxide) is used as a transparent conductive material for forming the junction layer 120 and the rear transparent electrode 140, the junction layer 120 and the rear transparent electrode 140 may be deposited by sputtering. It is also possible to deposit an n-type amorphous silicon layer instead of a transparent conductive oxide as the junction layer 120 by PECVD.

Referring to Fig. 13C, a rear passivation layer 240 is formed on the rear surface of the crystalline silicon solar cell 210, and a junction layer 220 is formed on the front surface thereof.

In this embodiment, before the junction layer 220 is formed, in order to reduce the surface defects of the emitter layer 212 and to secure the conductivity for the tunnel junction, a junction layer 220 may be formed after a 0.5 to 10 nm thick passivation layer 221 is formed on the front surface of the emitter layer 212. For example, the passivation layer may be made of SiOₓ and may be formed through a wet process, ozone treatment, or PECVD. Then, the junction layer 220 may be formed by sequentially depositing a p+ type crystalline silicon layer and an n+ type crystalline silicon layer having a thickness of 50 to 500 nm on the front surface of the passivation layer. The rear passivation layer 240 may be formed through a deposition with PECVD from silicon oxide (SiOₓ), silicon nitride (SiₓN_{y}), or silicon oxynitride (SiOₓN_{y}).

Referring to Fig. 13D, a pad electrode 281 penetrating the rear passivation layer 240 is formed. The pad electrode 281 may be formed by patterning Ag, Al or Ag-Al paste on the rear surface of the rear passivation layer 240 through screen printing, followed by drying and heat treatment. The pad electrode 281 patterned through the heat treatment can be in contact with the rear electric field layer 213.

Referring to Figs. 12D, 12E and 13E, perovskite solar cells 130 and 230 are formed on the front surfaces of the junction layers 120 and 220.

First, the electron transfer layers 131 and 231 are formed on the front surfaces of the junction layers 120 and 220, and then mesoporous layers 131a and 231a are formed on the front surfaces of the electron transfer layers 131 and 231. In this embodiment, the electron transport layers 131 and 231 and the mesoporous layers 131a and 231a may be formed of a same metal oxide.

For example, the electron transport layers 131 and 231 may be formed to a thickness of 5 to 100 nm, and the mesoporous layers 131a and 231a may be formed with a TiO₂ layer having a thickness of 500 nm or less. Perovskite absorption layers 132 and 232 are formed on the mesoporous layers 131a and 231a, and the perovskite absorption layers 132 and 232 may be formed to a thickness of 100 to 500 nm after filling mesopores in the mesoporous layers 131a and 231a. The hole transport layers 133 and 233 may be formed to a thickness of 5 to 100 nm by using a conductive polymer on the front surface of the perovskite absorption layers 132 and 232.

The respective layers constituting the perovskite solar cells 130 and 230 may be formed through for example physical vapor deposition, chemical vapor deposition, printing, or the like. In certain embodiments, the printing method includes ink jet printing, gravure printing, spray coating, doctor blade, bar coating, gravure coating, brush painting, slot-die coating, or the like.

Referring to Figs. 12F and 13F, the crystalline silicon solar cells 110 and 210 and the perovskite solar cells 130 and 230, which are tunnel-junctioned via the junction layers 120 and 220 are prepared, and then the front transparent electrodes 150 and 250 and the transparent electrode structures 160 and 260 are formed on the front surfaces of the perovskite solar cells 130 and 230.

In these embodiments, the front transparent electrodes 150 and 250 and the transparent electrode structures 160 and 260 may be formed using various transparent conductive materials as other layers to which transparent electrodes are applied. In addition, the front transparent electrodes 150 and 250 and the transparent electrode structures 160 and 260 may be formed of the same or different transparent conductive materials.

For example, when a transparent conductive oxide such as ITO (Indium Tin Oxide) is used as the transparent conductive material for forming the front transparent electrodes 150 and 250, the front transparent electrodes 150 and 250 may be deposited through sputtering.

The method of patterning the transparent electrode structures 160 and 260 on the front surface of the front transparent electrodes 150 and 250 may be appropriately selected in consideration of the pattern shape of the transparent electrode structures 160 and 260 and the number of processes.

For example, the transparent electrode structures 160 and 260 shown in Figs. 2 and 9 may be formed by depositing the front transparent electrodes 150 and 250 and the transparent electrode structures 160 and 260 as separate layers by sputtering, and then introducing a nano-sized structure into the transparent electrode structures 160 and 260 deposited in the form of a single layer or etching to form a lattice pattern such as a grid or a mesh pattern. In these embodiments, the front transparent electrodes 150 and 250 may be exposed in the region where the transparent electrode structures 160 and 260 are etched. According to another embodiment, an appropriate amount of the nano-spherical solution is applied on the front surface of the front transparent electrode 150, and then the transparent electrode structures 160 and 260 can be formed to have a grid or a mesh pattern through a self-assembly induction method as an energy such as ultrasonic waves is applied.

The transparent electrode structures 160 and 260 shown in Figs. 3 and 10 are formed to have a concave-convex pattern by controlling the degree of etching of the transparent electrode structure 160. The transparent electrode structures 160 and 260 shown in Figs. 4 and 11 are integrally formed with the front transparent electrodes 150 and 260. That is, the patterned transparent electrode structures 160 and 260 can be introduced on the front surfaces of the front transparent electrodes 150 and 250 by depositing the front transparent electrodes 150 and 250 and then etching them to a predetermined depth.

Although all of the above-described methods have been described for planarizing the front surface of a silicon substrate to form a perovskite layer and a transparent electrode, it can also be prepared in such a way that the front surface of the silicon substrate is finely etched and a perovskite solar cell layer is formed thereon, to thereby transfer its shape to the transparent electrode.

Then, referring to Fig. 12G, a front metal electrode 170 is formed on the front surface of the front transparent electrode 150 and a rear metal electrode 180 is formed on the rear surface of the rear transparent electrode 140. In particular, it is preferable that the rear metal electrode 180 is formed only on a part of the rear surface of the rear transparent electrode 140 so that the light of a longer wavelength not absorbed by the crystalline silicon solar cell 110 can be emitted to the rear surface.

In this embodiment, the front metal electrode 170 and the rear metal electrode 180 include grid electrodes 171 and 181, and may selectively include pad electrodes (not shown). The front metal electrode 170 and the rear metal electrode 180 including the grid electrodes 171 and 181 and the pad electrodes may be formed by screen printing Ag, Al, or Ag-Al paste, followed by heat treatment at 100 to 150°C to be in contact with the front transparent electrode 150 and the rear transparent electrode 140, respectively.

Referring to Fig. 13G, a front metal electrode 270 is formed on the front surface of the front transparent electrode 250 in the same manner as in Fig. 12G.

### [Tandem solar cell module]

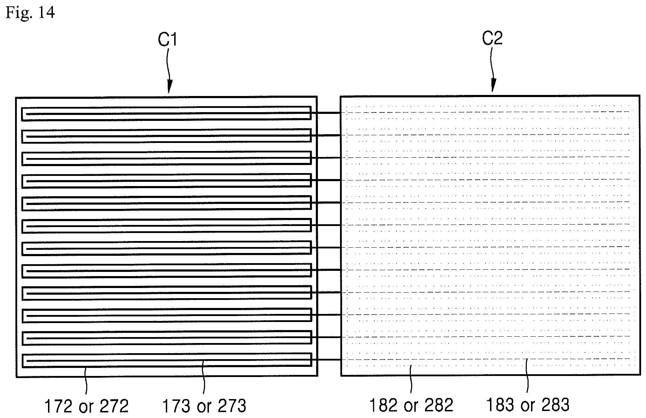

Fig. 14 schematically shows a tandem solar cell according to the present disclosure connected in series. Each solar cell is subjected to a modularization step of electrically connecting and packaging a plurality of cells in order to increase the output and protect the solar cell from moisture or external impact.

Accordingly, according to another aspect of the present disclosure, the tandem solar cell disclosed herein can be modularized by connecting two neighboring tandem solar cells in series using a conductor.

Referring to Fig. 14, two adjacent tandem solar cells C1 and C2 are connected to each other by electrode wires 173 and 183. In this embodiment, two neighboring tandem solar cells can be connected to each other by a multi wire tabbing method.

For example, one of the electrode wires 173 and 273 is soldered to the pad electrodes 172 and 272 located on the front surface of the arbitrary tandem solar cell C1, and the other of the electrode wires 173 and 273 is soldered to the pad electrodes 182 and 282 located on the rear surface of the other tandem solar cell C2.

An electrode wire made of Cu, Ag, Ni or Al coated with a solder material (e.g., Pb, Sn, SnIn, SnBi, SnPb, Sn, SnCuAg or SnCu) can be used as a conductor for connecting two neighboring tandem solar cells in series. The electrode wires 173 and 183 may be attached on the pad electrodes 172 and 182 through various methods such as soldering.

In this embodiment, the electrode wires 173 and 183 are preferably a wire form having a cylindrical or elliptical cross section. Accordingly, the light incident vertically toward the electrode wires 173 and 183 can be scattered to increase the probability of re-entering into the tandem solar cell, thereby improving the photoelectric conversion efficiency.

Additionally, the front transparent substrate 190 and the rear transparent substrate 200 are bonded to each other with gaps 195 and 205, respectively, on the front and rear surfaces of the tandem solar cell module in which a plurality of cells is electrically connected to each other. In this embodiment, the gaps 195 and 205 may be sealing layers filled with an encapsulating material such as a sealant. Further, according to another embodiment, a module may be provided in which gaps 195 and 205 between the tandem solar cell and the front transparent substrate 190 and the rear transparent substrate 200 are formed with an air layer filled with a gas such as air without filling with an encapsulating material.

In this embodiment, a glass substrate, a transparent polymer substrate, or the like may be used, as the front transparent substrate 190 and the rear transparent substrate 200. In this embodiment, the corner portion of the tandem solar cell module may be sealed using an encapsulating material and another sealing member.

Although the foregoing disclosure has been described in some detail by way of illustration and example for purposes of clarity of understanding with reference to exemplary embodiments thereof, it will be obvious that certain changes and modifications may be practiced within the scope of the appended claims. Moreover, even though the embodiments of the present disclosure have been described, while the functional effects based on the constitution of the present disclosure have not been explicitly described, it should be appreciated that predictable effects should also be recognized by the constitution.

## Claims

1. A tandem solar cell in which a perovskite solar cell (130, 230) and a crystalline silicon solar cell (110, 210) are bonded, comprising:
a junction layer (120, 220) disposed on a front surface of the crystalline silicon solar cell (110, 220);
a perovskite solar cell (130, 230) disposed on a front surface of the junction layer; and
a front transparent electrode (150, 250) disposed on a front surface of the perovskite solar cell; **characterised by**
a transparent electrode structure (160, 260) disposed on a front surface of the front transparent electrode and comprising a patterned transparent electrode.

2. The tandem solar cell of claim 1, wherein the transparent electrode structure (160, 260) has a nano-structure, a concave-convex pattern or a grid pattern.

3. The tandem solar cell of claim 1 or 2, wherein the front transparent electrode (150, 250) and the transparent electrode structure (160, 260) are integrally formed.

4. The tandem solar cell of any one preceding claim, wherein the crystalline silicon solar cell (110) comprises:
a crystalline silicon substrate (111) having a textured structure on the rear surface thereof;
a front i-type amorphous silicon layer (112) and a rear i-type amorphous silicon layer (113) disposed respectively on front and rear surfaces of the crystalline silicon substrate;
a first conductive amorphous silicon layer (114) disposed on a front surface of the front i-type amorphous silicon layer; and
a second conductive amorphous silicon layer (115) disposed on a rear surface of the rear i-type amorphous silicon layer.

5. The tandem solar cell of claim 4, wherein the second conductive amorphous silicon layer (115) is disposed on a front surface of a rear transparent electrode (140).

6. The tandem solar cell of claim 5, wherein a rear metal electrode (180) is disposed on a part of a rear surface of the rear transparent electrode (140).

7. The tandem solar cell of any one preceding claim, wherein the crystalline silicon solar cell (220) comprises:
a crystalline silicon substrate (211) having a textured structure on the rear surface thereof;
an emitter layer (212) disposed on a front surface of the crystalline silicon substrate; and
a rear electric field layer (213) disposed on a rear surface of the crystalline silicon substrate.

8. The tandem solar cell of claim 7, wherein the emitter layer (212) is an impurity doping layer having conductivity different from that of the crystalline silicon substrate, and the rear electric field layer (213) is an impurity doping layer having the same conductivity as that of the crystalline silicon substrate.

9. The tandem solar cell of claim 7 or 8, wherein the rear electric field layer (213) is disposed on a front surface of a rear passivation layer (240).

10. The tandem solar cell of claim 9, wherein a rear metal electrode (180) is disposed on a part of a rear surface of the rear passivation layer (240), and the rear metal electrode (180) contacts a rear surface of the rear electric field layer (213) through the rear passivation layer (240).

11. The tandem solar cell of any one preceding claim, wherein the perovskite solar cell (130, 230) comprises:
an electron transport layer (131, 231) disposed on a front surface of the junction layer (120, 220);
a perovskite absorption layer (131, 232) disposed on a front surface of the electron transfer layer (131, 231); and
a hole transport layer (133, 233) disposed on a front surface of the perovskite absorption layer.

12. The tandem solar cell of claim 11, further comprising a mesoporous layer (131a, 231a) on a front surface of the electron transport layer (131, 231).

13. A tandem solar cell module comprising a plurality of tandem solar cells, each of said tandem solar cells comprising:
the tandem solar cell of claim 1; a front metal electrode (170. 270) disposed on a front surface of the transparent electrode structure; and
a rear metal electrode (180. 280) disposed on a rear surface of the crystalline silicon solar cell, wherein the front metal electrode and the rear metal electrode of neighboring two tandem solar cells among the plurality of tandem solar cells are electrically connected to each other by electrode wires (173, 273), and comprises a front transparent substrate and a rear transparent substrate disposed with a gap on the front and rear surfaces of the plurality of tandem solar cells.

14. The tandem solar cell module of claim 13, wherein an encapsulating material or a gas-filled air layer is formed between the front surface of the plurality of tandem solar cells and the front transparent substrate (190), or between the rear surface of the plurality of tandem solar cells and the rear transparent substrate (200).

15. The tandem solar cell module of claim 13 or 14, wherein both sides of the tandem solar cell module are sealed with an encapsulating material.

## Patentansprüche

1. Tandemsolarzelle, in der eine Perowskit-Solarzelle (130, 230) und eine kristalline Siliciumsolarzelle (110, 210) gebunden sind, umfassend:
eine Verbindungsschicht (120, 220), die auf einer Vorderseite der kristallinen Siliciumsolarzelle (110, 220) angeordnet ist;
eine Perowskit-Solarzelle (130, 230), die auf einer Vorderseite der Verbindungsschicht angeordnet ist; und
eine vordere transparente Elektrode (150, 250), die auf einer Vorderseite der Perowskit-Solarzelle angeordnet ist;
**gekennzeichnet durch**
eine transparente Elektrodenstruktur (160, 260), die auf einer Vorderseite der vorderen transparenten Elektrode angeordnet ist und eine gemusterte transparente Elektrode umfasst.

2. Tandemsolarzelle nach Anspruch 1, wobei die transparente Elektrodenstruktur (160, 260) eine Nanostruktur, ein konkav-konvexes Muster oder ein Gittermuster aufweist.

3. Tandemsolarzelle nach Anspruch 1 oder 2, wobei die vordere transparente Elektrode (150, 250) und die transparente Elektrodenstruktur (160, 260) einstückig ausgebildet sind.

4. Tandemsolarzelle nach einem der vorhergehenden Ansprüche, wobei die kristalline Siliciumsolarzelle (110) umfasst:
ein kristallines Siliciumsubstrat (111) mit einer texturierten Struktur auf seiner Rückseite;
eine vordere amorphe Siliciumschicht vom i-Typ (112) und eine hintere amorphe Siliciumschicht vom i-Typ (113), die jeweils auf einer Vorder- und Rückseite des kristallinen Siliciumsubstrats angeordnet sind;
eine erste leitfähige amorphe Siliciumschicht (114), die auf einer Vorderseite der vorderen amorphen Siliciumschicht vom i-Typ angeordnet ist; und
eine zweite leitfähige amorphe Siliciumschicht (115), die auf einer Rückseite der hinteren amorphen Siliciumschicht vom i-Typ angeordnet ist.

5. Tandemsolarzelle nach Anspruch 4, wobei die zweite leitfähige amorphe Siliciumschicht (115) auf einer Vorderseite einer hinteren transparenten Elektrode (140) angeordnet ist.

6. Tandemsolarzelle nach Anspruch 5, wobei eine hintere Metallelektrode (180) auf einem Teil einer Rückseite der hinteren transparenten Elektrode (140) angeordnet ist.

7. Tandemsolarzelle nach einem der vorhergehenden Ansprüche, wobei die kristalline Siliciumsolarzelle (220) umfasst:
ein kristallines Siliciumsubstrat (211) mit einer texturierten Struktur auf seiner Rückseite;
eine Emitterschicht (212), die auf einer Vorderseite des kristallinen Siliciumsubstrats angeordnet ist; und
eine hintere elektrische Feldschicht (213), die auf einer Rückseite des kristallinen Siliciumsubstrats angeordnet ist.

8. Tandemsolarzelle nach Anspruch 7, wobei die Emitterschicht (212) eine Störstellendotierungsschicht ist, deren Leitfähigkeit sich von der des kristallinen Siliciumsubstrats unterscheidet, und die hintere elektrische Feldschicht (213) eine Störstellendotierungsschicht ist, die dieselbe Leitfähigkeit wie die des kristallinen Siliciumsubstrats aufweist.

9. Tandemsolarzelle nach Anspruch 7 oder 8, wobei die hintere elektrische Feldschicht (213) auf einer Vorderseite einer hinteren Passivierungsschicht (240) angeordnet ist.

10. Tandemsolarzelle nach Anspruch 9, wobei eine hintere Metallelektrode (180) auf einem Teil einer Rückseite der hinteren Passivierungsschicht (240) angeordnet ist und die hintere Metallelektrode (180) eine Rückseite der hinteren elektrischen Feldschicht (213) durch die hintere Passivierungsschicht (240) berührt.

11. Tandemsolarzelle nach einem der vorhergehenden Ansprüche, wobei die Perowskit-Solarzelle (130, 230) umfasst:
eine Elektronentransportschicht (131, 231), die auf einer Vorderseite der Verbindungsschicht (120, 220) angeordnet ist;
eine Perowskit-Absorptionsschicht (131, 232), die auf einer Vorderseite der Elektronentransferschicht (131, 231) angeordnet ist; und
eine Lochtransportschicht (133, 233), die auf einer Vorderseite der Perowskit-Absorptionsschicht angeordnet ist.

12. Tandemsolarzelle nach Anspruch 11, ferner umfassend eine mesoporöse Schicht (131a, 231a) auf einer Vorderseite der Elektronentransportschicht (131, 231).

13. Tandemsolarzellenmodul, das eine Mehrzahl von Tandemsolarzellen umfasst, wobei jede der Tandemsolarzellen umfasst:
die Tandemsolarzelle nach Anspruch 1;
eine vordere Metallelektrode (170, 270), die auf einer Vorderseite der transparenten Elektrodenstruktur angeordnet ist; und
eine hintere Metallelektrode (180, 280), die auf einer Rückseite der kristallinen Siliciumsolarzelle angeordnet ist, wobei die vordere Metallelektrode und die hintere Metallelektrode von zwei benachbarten Tandemsolarzellen unter der Mehrzahl von Tandemsolarzellen durch Elektrodendrähte (173, 273) elektrisch miteinander verbunden sind und ein vorderes transparentes Substrat und ein hinteres transparentes Substrat umfassen, die mit einem Spalt auf der Vorder- und Rückseite der Mehrzahl von Tandemsolarzellen angeordnet sind.

14. Tandemsolarzellenmodul nach Anspruch 13, wobei ein Einkapselungsmaterial oder eine gasgefüllte Luftschicht zwischen der Vorderseite der Mehrzahl von Tandemsolarzellen und dem vorderen transparenten Substrat (190) oder zwischen der Rückseite der Mehrzahl von Tandemsolarzellen und dem hinteren transparenten Substrat (200) ausgebildet ist.

15. Tandemsolarzellenmodul nach Anspruch 13 oder 14, wobei beide Seiten des Tandemsolarzellenmoduls mit einem Einkapselungsmaterial versiegelt sind.

## Revendications

1. Cellule solaire tandem dans laquelle sont collées une cellule solaire en pérovskite (130, 230) et une cellule solaire en silicium cristallin (110, 210), comprenant :
une couche de jonction (120, 220) disposée sur une face avant de la cellule solaire en silicium cristallin (110, 220) ;
une cellule solaire en pérovskite (130, 230) disposée sur une face avant de la couche de jonction ; et
une électrode avant transparente (150, 250) disposée sur une face avant de la cellule solaire en pérovskite ; **caractérisée par**
une structure d'électrode transparente (160, 260) disposée sur une face avant de l'électrode transparente avant et comprenant une électrode transparente à motif.

2. Cellule solaire tandem selon la revendication 1 la structure d'électrode transparente (160, 260) ayant une nano-structure, un motif concave-convexe ou un motif en grille.

3. Cellule solaire tandem selon la revendication 1 ou 2, l'électrode transparente avant (150, 250) et la structure d'électrode transparente (160, 260) étant formées d'un seul tenant.

4. Cellule solaire tandem selon l'une quelconque des revendications précédentes, la cellule solaire en silicium cristallin (110) comprenant :
un substrat en silicium cristallin (111) ayant une structure texturée sur sa face arrière ;
une couche de silicium amorphe avant de type i (112) et une couche de silicium amorphe arrière de type i (113) disposées respectivement sur les faces avant et arrière du substrat de silicium cristallin ;
une première couche de silicium amorphe conductrice (114) disposée sur une face avant de la couche de silicium amorphe avant de type i ; et
une seconde couche de silicium amorphe conductrice (115) disposée sur une face arrière de la couche de silicium amorphe arrière de type i.

5. Cellule solaire tandem selon la revendication 4, la seconde couche de silicium amorphe conductrice (115) étant disposée sur une face avant d'une électrode transparente arrière (140).

6. Cellule solaire tandem selon la revendication 5, une électrode métallique arrière (180) étant disposée sur une partie d'une face arrière de l'électrode transparente arrière (140).

7. Cellule solaire tandem selon l'une quelconque des revendications précédentes, la cellule solaire en silicium cristallin (220) comprenant :
un substrat de silicium cristallin (211) ayant une structure texturée sur sa face arrière ;
une couche d'émetteur (212) disposée sur une face avant du substrat de silicium cristallin ; et
une couche de cham électrique arrière (213) disposée sur une face arrière du substrat de silicium cristallin.

8. Cellule solaire tandem selon la revendication 7, la couche d'émetteur (212) étant une couche dopée aux impuretés ayant une conductivité différente de celle du substrat de silicium cristallin, et la couche de champ électrique arrière (213) étant une couche dopée aux impuretés ayant la même conductivité que celle du substrat de silicium cristallin.

9. Cellule solaire tandem selon la revendication 7 ou 8, la couche de champ électrique arrière (213) étant disposée sur une face avant d'une couche de passivation arrière (240).

10. Cellule solaire tandem selon la revendication 9, une électrode métallique arrière (180) étant disposée sur une partie d'une face arrière de la couche de passivation arrière (240), et l'électrode métallique arrière (180) entrant en contact avec une face arrière de la couche de champ électrique arrière (213) par l'intermédiaire de la couche de passivation arrière (240).

11. Cellule solaire tandem selon l'une quelconque des revendications précédentes la cellule solaire en pérovskite (130, 230) comprenant :
une couche de transport d'électrons (131, 231) disposée sur une face avant de la couche de jonction (120, 220) ;
une couche d'absorption de pérovskite (131, 232) disposée sur une face avant de la couche de transfert d'électrons (131, 231) ; et
une couche de transport à trou (133, 233) disposée sur une face avant de la couche d'absorption de pérovskite.

12. Cellule solaire tandem selon la revendication 11, comprenant en outre une couche mésoporeuse (131a, 231a) sur une face avant de la couche de transport d'électrons (131, 231).

13. Module de cellules solaires tandem comprenant une pluralité de cellules solaires tandem, chacune desdites cellules solaires tandem comprenant :
la cellule solaire tandem selon la revendication 1 ;
une électrode métallique avant (170, 270) disposée sur une face avant de la structure d'électrode transparente ; et
une électrode métallique arrière (180, 280) disposée sur une face arrière de la cellule solaire en silicium cristallin, l'électrode métallique avant et l'électrode métallique arrière de deux cellules solaires tandem avoisinantes parmi la pluralité des cellules solaires tandem étant connectées électriquement l'une à l'autre par des fils d'électrodes (173, 273), et comprenant un substrat transparent avant et un substrat transparent arrière, un espace se trouvant sur les faces avant et arrière de la pluralité de cellules solaires tandem.

14. Module de cellules solaires tandem selon la revendication 13, un matériau d'encapsulation ou une couche d'air rempli de gaz étant formé(e) entre la face avant de la pluralité de cellules solaires tandem et le substrat transparent avant (190), ou entre la face arrière de la pluralité de cellules solaires tandem et le substrat transparent arrière (200).

15. Module de cellules solaires selon la revendication 13 ou 14, chaque côté du module de cellules solaires étant rendu étanche par un matériau d'encapsulation.
